# EUROPÄISCHE PATENTSCHRIFT

(11) **EP 1 507 627 B1**
(45) Veröffentlichungstag und Bekanntmachung des Hinweises auf die Patenterteilung: **21.06.2006**
(21) Anmeldenummer: 03735341.4
(22) Anmeldetag: 20.03.2003
(51) Int. Cl.: B23Q 1/66, B23Q 39/04, B23Q 1/01, B23Q 3/155, H05K 3/00

(54) **AUTOMATISIERTE WEKZEUGMASCHINE**
AUTOMATIC MACHINE TOOL
MACHINE-OUTIL AUTOMATISEE

(30) Priorität: 15.05.2002 DE 10221532
(43) Veröffentlichungstag der Anmeldung: 23.02.2005
(73) Patentinhaber: Schmoll Maschinen Gmbh, 63322 Rödermark-Oberroden (DE)
(72) Erfinder: KUNZ, Thomas, 61462 Königstein (DE)
(74) Vertreter: KEIL & SCHAAFHAUSEN Patentanwälte
(86) Internationale Anmeldenummer: PCT/EP2003/002943
(87) Internationale Veröffentlichungsnummer: WO 2003/097295

(56) Entgegenhaltungen:
- WO-A-02/26440
- DE-A- 3 936 947
- US-B1- 6 325 576
- BETZ R: "MEHRSPINDELBOHREN EIN NEUES VERFAHREN FUER LEITERPLATTEN" F & M FEINWERKTECHNIK MIKROTECHNIK MIKROELEKTRONIK, CARL HANSER GMBH & CO, DE, Bd. 104, Nr. 9, 1. September 1996 (1996-09-01), Seiten S12-S15, XP000636596 ISSN: 0944-1018

## Beschreibung

Die Erfindung bezieht sich auf eine automatisierte Werkzeugmaschine mit mehreren Arbeitsstationen, insbesondere Bohrmaschine für Leiterplatten mit mehreren Bohrstationen, wobei jede Arbeitsstation mehrere, vorzugsweise in einer Linie nebeneinander montierte und in einer ersten Richtung relativ zueinander verstellbare Arbeitseinheiten, insbesondere Bohrspindeleinheiten, sowie einen eigenen in einer zweiten Richtung verstellbaren Werkstückträger aufweist.

Eine derartige Werkzeugmaschine, bei welcher die Arbeitsstationen mit ihren Arbeitseinheiten auf einer gemeinsamen starren Maschinenbasis angeordnet sind, ist aus der WO 02/26440 A1 bekannt. Dabei sind mehrere Arbeitseinheiten auf einem gemeinsamen Träger vorgesehen, so dass die Arbeitseinheiten nur gemeinsam bewegt werden können.

Aus der DE-U-297 12 034 ist eine automatisierte Leiterplatten-Bohrmaschine bekannt, bei weicher mehrere mehrspindlige Bohrstationen in einer Linie separat und in festem Abstand voneinander angeordnet einer gemeinsamen Leiterplatten-Transporteinrichtung zugeordnet sind. Jede Bohrstation hat einen Aufspanntisch für die zu bohrenden Leiterplatten bzw. Leiterplattenpakete und wenigstens eine Bohrspindeleinheit, wobei der Aufspanntisch und die Bohrspindeleinheiten relativ zueinander in X-Achse, in Y-Achse und in Z-Achse verstellbar sind. Jede Bohrstation hat ferner wenigstens ein eigenes Werkzeugmagazin mit der Möglichkeit des selbständigen Werkzeugwechsels.

Derartige Bohrmaschinen haben den Nachteil eines großen Platzbedarfs, einer aufwendigen Steuerungstechnik, da jede Bohrstation eine eigene Steuerung aufweist, sowie einer komplizierten Werkzeugverwaltung. Diese Nachteile wirken sich insbesondere auch auf die begrenzte Arbeitsgeschwindigkeit aus, welche jedoch insbesondere bei Bohrmaschinen für Leiterplatten, bei welchen eine große Anzahl von Löchern mit hoher Geschwindigkeit und höchster Präzision gebohrt werden müssen.

Aufgabe der vorliegenden Erfindung ist es, eine Werkzeugmaschine der eingangs genannten Art so auszubilden, dass bei einer kompakten Bauweise und hoher Arbeitsgeschwindigkeit auch Leiterplatten mit unterschiedlicher Bohrlochverteilung herstellbar sind.

Diese Aufgabe wird bei einer Werkzeugmaschine der eingangs genannten Art bspw. dadurch gelöst, dass die Arbeitseinheiten der einzelnen Arbeitsstationen sowie die den einzelnen Arbeitsstationen eigenen Werkstückträger unabhängig voneinander verstellbar sind.

Hierdurch können trotz einer gemeinsamen Maschinensteuerung in den Arbeitsstationen mit hoher Genauigkeit bspw. Leiterplatten unterschiedlichster Bohrlochverteilung gleichzeitig hergestellt werden. Der Umstand der Anordnung aller Arbeitsstationen auf einer gemeinsamen starren Maschinenbasis, bspw. einem Granitblock, gewährleistet eine kompakte Bauweise bei höchster Präzision, was insbesondere für Leiterplatten-Bohrmaschinen wichtig ist. Eine gemeinsame Werkzeugverwaltung kann dabei zu einer besonders rationellen Werkzeugbestückung führen. Dies ist ebenfalls insbesondere bei Bohrmaschinen für Leiterplatten mit mehreren Bohrstationen von besonderem Vorteil, weil hierbei die einzelnen Bohrer nur für eine begrenzte Anzahl von Bohrungen eingesetzt und dann gegen einen neuen Bohrer ausgetauscht werden müssen. Dies muss mit hoher Geschwindigkeit erfolgen, um Stillstandszeiten möglichst kurz zu halten.

Bei einer besonderen Ausgestaltung der Erfindung ist allen Arbeitseinheiten eine gemeinsame erste Führung, z. B. in Form von in der ersten Richtung verlaufenden ersten Führungsschienen, zugeordnet. Auf diese Weise hat die Werkzeugmaschine einen einfachen übersichtlichen Aufbau, welcher auch die Bedienung erleichtert. Die Zuordnung je einer eigenen ersten Führung zu jeder Arbeitseinheit kann auch zweckmäßig sein.

Ein weiteres Erfindungsmerkmal wird darin gesehen, dass die Werkstückträger jeweils eigene zweite Führungen, z. B. in Form von in der zweiten Richtung verlaufenden zweiten Führungsschienen, aufweisen. Hierdurch wird bei zuverlässiger Funktion die unabhängige Führung der einzelnen Werkstückträger gewährleistet.

Von besonderem Vorteil ist auch, wenn die erste Führung an dem Querträger eines portalartigen Aufsatzes des Maschinenbettes vorgesehen ist. Der portalartige Aufsatz erhält aufgrund seiner Verbindung mit der massiven Maschinenbasis ebenfalls hohe Stabilität, wobei aufgrund der portalartigen Ausgestaltung der Platz unter dem Querträger für die Bewegung der Werkstückträger in der zweiten Richtung ausgenutzt werden kann. Dabei ist die Werkzeugmaschine bspw. von beiden Längsseiten aus zugänglich und bedienbar.

In weiterer besonderer Ausgestaltung des Erfindungsgedankens sind die zweiten Führungen unmittelbar auf der Oberseite der Maschinenbasis vorgesehen. Auf diese Weise wird die massive Maschinenbasis dazu ausgenutzt, eine präzise Führung der Werkstückträger zu gewährleisten.

Genauigkeit der Positionierung der einzelnen Arbeitseinheiten in Arbeitsstellung kann weiterhin dadurch erhöht werden, was insbesondere beim Bohren von Leiterplatten von Bedeutung ist, das den jeweiligen Antriebsmitteln für die Arbeitseinheiten und/oder die Werkstückträger ein Positionsmesssystem zugeordnet ist, welches mit der Programmsteuerung der einzelnen Arbeitseinheiten und Werkstückträger zusammen arbeitet.

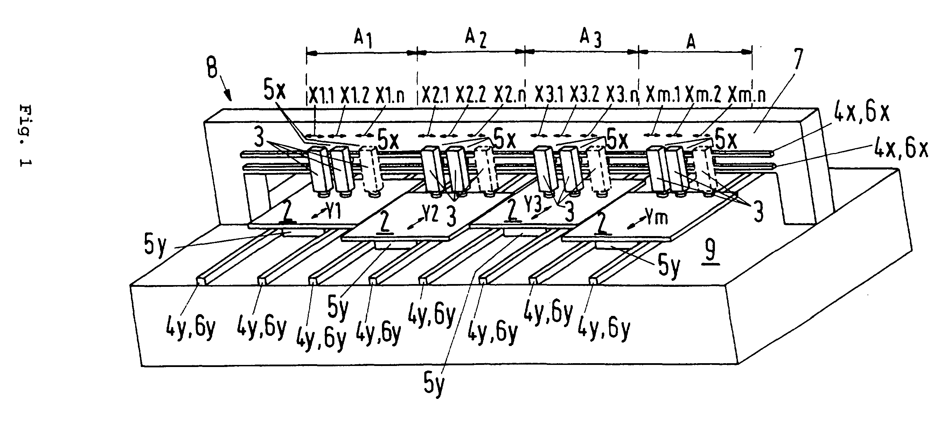

Weiter Ziele, Merkmale, Vorteile und Anwendungsmöglichkeiten der vorliegenden Erfindung ergeben sich aus der nachfolgenden Beschreibung von Ausführungsbeispielen anhand der Zeichnung. Dabei bilden alle beschriebenen und/oder bildlich dargestellten Merkmale für sich oder in beliebiger Kombination den Gegenstand der vorliegenden Erfindung auch unabhängig von ihrer Zusammenfassung in einzelnen Ansprüchen oder deren Rückbeziehung.

Die einzige Figur veranschaulicht in Schrägansicht eine die Erfindung verwirklichende automatisierte Werkzeugmaschine am Beispiel einer Bohrmaschine für Leiterplatten.

Die in der Zeichnung dargestellte Werkzeugmaschine hat mehrere als Bohrstationen ausgebildete Arbeitsstationen A, um als Bohrmaschine für Leiterplatten zu dienen. Alle Arbeitsstationen A sind nebeneinander auf einer gemeinsamen starren Maschinenbasis 1, die z. B. aus einem tonnenschweren Granitblock gebildet ist, angeordnet. Die Arbeitsstationen A sind dabei in einer Linie montiert und weisen jeweils mehre als Bohrspindeleinheiten ausgebildete Arbeitseinheiten 3 auf. Die Arbeitseinheiten 3 sind in einer ersten Richtung (X-Achse) relativ zueinander verstellbar. Jeder Gruppe von Arbeitseinheiten 3 einer Arbeitsstation A ist je ein eigener Werkstückträger 2, bspw. für die Aufnahme einer zu bohrenden Leiterplatte oder eines zu bohrenden Leiterplattenpakets, zugeordnet. Die Werkstückträger 2 der einzelnen Arbeitsstationen A sind unabhängig voneinander in einer zweiten Richtung (Y-Achse) verstellbar, wobei die Y-Achse senkrecht zu der X-Achse steht. Allen Arbeitseinheiten 3 sind eine gemeinsame Maschinensteuerung und eine (nicht dargestellte) gemeinsame Werkzeugverwaltung, insbesondere in Form eines gemeinsamen Werkzeugmagazins, zugeordnet. Das Werkzeugmagazin dient dabei dem Invorrathalten ungebrauchter Werkzeuge, z. B. Bohrer, und zur Wiederaufnahme bereits abgenutzter Werkzeuge, z. B. Bohrer.

Bei der dargestellten Ausführungsform ist allen Arbeitseinheiten 3 eine gemeinsame erste Führung 4x in Form von zwei in der ersten Richtung X parallel zueinander verlaufenden ersten Führungsschienen 6x zugeordnet. Die Führungsschienen sind an einem Querträger 7 eines portalartigen Aufsatzes 8 der Maschinenbasis 1 angebracht, welcher praktisch die gesamte Maschinenbasis 1 überspannt. Die Führungsschienen 6x dienen dabei nicht nur der Führung der einzelnen Arbeitseinheiten 3, sondern an ihnen greifen auch entsprechende erste Antriebsmittel 5x an, von denen jeweils eines jeweils einer Arbeitseinheit 3 zugeordnet ist, um einer voneinander unabhängige Relativbewegung der Arbeitseinheiten 3 zu gewährleisten.

Die Werkstückträger 2 haben jeweils eigene zweite Führungen 4y in Form von zwei in der zweiten Richtung Y parallel zueinander verlaufenden zweiten Führungsschienen 6y, welche auf der Oberseite 9 der massiven Maschinenbasis 1 montiert sind. Den einzelnen Werkstückträgern 2 ist jeweils ein zweites Antriebsmittel 5y zugeordnet, welches an den jeweils zwei Führungsschienen 6y angreift, wobei die Werkstückträger 2 aufgrund der portalartigen Ausgestaltung des Aufsatzes 8 auch teilweise oder ganz unter dem Aufsatz 8 hindurchbewegt werden können.

Den jeweiligen Antriebsmitteln 5x, 5y für die Arbeitseinheiten 3 und/oder die Werkstückträger 2 ist ein (nicht dargestelltes) Positionsmesssystem zugeordnet, so dass bspw. die Vielzahl von Löchern einer Leiterplatte bzw. eines Leiterplattenpakets mit hoher Präzision und Geschwindigkeit angesteuert und gebohrt werden kann.

### Bezugszeichenliste

- 1: Maschienenbasis
- 2: Werkstückträger
- 3: Arbeitseinheiten
- 4x: erste Führung
- 4y: zweite Führungen
- 5x: erste Antriebsmittel
- 5y: zweite Antriebsmittel
- 6x: erste Führungsschienen
- 6y: zweite Führungsschienen
- 7: Querträger
- 8: Aufsatz
- 9: Oberseite der Maschinenbasis

- A: Arbeitsstationen

## Patentansprüche

1. Automatisierte Werkzeugmaschine mit mehreren Arbeitsstationen (A), insbesondere Bohrmaschine für Leiterplatten mit mehreren Bohrstationen, wobei jede Arbeitsstation (A) mehrere vorzugsweise in einer Linie nebeneinander montierte und in einer ersten Richtung (X-Achse) relativ zueinander verstellbare Arbeitseinheiten (3), insbesondere Bohrspindeleinheiten, sowie einen eigenen in einer zweiten Richtung (Y-Achse) verstellbaren Werkstückträger (2) aufweist, wobei alle Arbeitsstationen (A) mit ihren jeweils mehreren Arbeitseinheiten (3) nebeneinander auf einer gemeinsamen starren Maschinenbasis (1) angeordnet sind und/oder allen Arbeitseinheiten (3) eine gemeinsame Maschinensteuerung und/oder eine gemeinsame Werkzeugverwaltung, insbesondere ein gemeinsames Werkzeugmagazin, zugeordnet ist, **dadurch gekennzeichnet, dass** die Arbeitseinheiten (3) der einzelnen Arbeitsstationen (A) sowie die den einzelnen Arbeitsstationen (A) eigenen Werkstückträger (2) unabhängig voneinander verstellbar sind.

2. Werkzeugmaschine nach Anspruch 1, **dadurch gekennzeichnet, dass** allen Arbeitseinheiten (3) eine gemeinsame erste Führung (4x), z.B. in Form von in der ersten Richtung (X-Achse) verlaufenden ersten Führungsschienen (6x), zugeordnet ist.

3. Werkzeugmaschine nach Anspruch 1 oder 2, **dadurch gekennzeichnet, dass** die Werkstückträger (2) jeweils eigene zweite Führungen (4y), z.B. in Form von in der zweiten Richtung (Y-Achse) verlaufenden zweiten Führungsschienen (6y), aufweisen.

4. Werkzeugmaschine nach Ansprüch 2, **dadurch gekennzeichnet, dass** die erste Führung (4x) an dem Querträger (7) eines portalartigen Aufsatzes (8) der Maschinenbasis (1) vorgesehen ist.

5. Werkzeugmaschine nach Ansprüche 3, **dadurch gekennzeichnet, dass** die zweiten Führungen (4y) auf der Oberseite (9) der Maschinenbasis (1) vorgesehen sind.

6. Werkzeugmaschine nach einem der Ansprüche 1 bis 5, **dadurch gekennzeichnet, dass** den jeweiligen Antriebsmitteln (5x, 5y) für die Arbeitseinheiten (3) und/oder die Werkstückträger (2) ein Positionsmesssystem zugeordnet ist.

## Claims

1. An automatic machine tool comprising a plurality of work stations (A), in particular, a drilling machine for printed circuit panels having a plurality of drilling stations, with each of said work stations (A) comprising a plurality of work units (3), in particular, a plurality of drill spindle units, preferably series arranged in side-by-side relationship and adjustable relative to one another in a first direction (X-axis), and comprising a workpiece holder (2) of its own which is adjustable in a second direction (Y-axis), with each of said work stations (A) with their given plurality of work units (3) being arranged in side-by-side relationship on a common rigid machine bed (1), and/or a common machine control and/or a common tool management, especially a common tool magazine, being associated to each of said work units (3), **characterized in that** the work units (3) of the said individual work stations (A) and the special workpiece holders (2) provided on the individual work stations (A) are adjustable independently of one another.

2. A machine tool according to claim 1, **characterized in that** a common first guide (4x), e.g. in the form of first guide rails (6x) extending in the first direction (X-axis), is associated to each of said work units (3).

3. A machine tool according to claims 1 or 2, **characterized in that** the workpiece holders (2) respectively comprise second guides (4y) of their own, e.g. in the form of second guide rails (6y) extending in the second direction (Y-axis).

4. A machine tool according to claim 2, **characterized in that** the said first guide (4x) is provided on the transverse holder (7) of a portal-type mount of the machine bed (1).

5. A machine tool according to claim 3, **characterized in that** the second guides (4y) are provided on the upper side (9) of the machine bed (1).

6. A machine tool according to any one of claims 1 to 5, **characterized in that** a position measuring system is associated to the given actuators (5x, 6y) for the work units (3) and/or the workpiece holders (2).

## Revendications

1. Machine-outil automatisée avec plusieurs stations de travail (A), notamment une perceuse pour des cartes de circuits imprimés avec plusieurs stations de perçage, chaque station de travail (A) étant munie de plusieurs unités de travail (3), notamment des unités broches de perçage, de préférence montées les unes à côté des autres sur une ligne et pouvant être déplacées les unes par rapport aux autres dans une première direction (axe X), ainsi qu'un porte-pièce (2) propre pouvant être déplacé dans une seconde direction (axe Y), toutes les stations de travail (A) étant disposées chacune avec ses différentes unités de travails (3) les unes à côté des autres sur une base de machine (1) rigide et/ou toutes les unités de travail (3) sont associées à une commande de machine commune et/ou à une gestion commune des outils, notamment un magasin d'outils commun, **caractérisée en ce que** les unités de travail (3) des différentes stations de travail (A) ainsi que les porte-pièce (7) propres à chaque station de travail (A) peuvent être déplacés indépendamment les uns des autres.

2. Machine-outil selon la revendication 1, **caractérisée en ce qu'**à toutes les unités de travail (3) est associé un premier guide commun (4x), ayant par exemple la forme de premiers rails de guidage (6x) s'étendant dans la première direction (axe X).

3. Machine-outil selon la revendication 1 ou 2, **caractérisée en ce que** chaque porte-pièce (2) est muni de deuxièmes guides (4y) propres, ayant par exemple la forme de deuxièmes rails de guidage (6y) s'étendant dans la deuxième direction (axe Y).

4. Machine-outil selon la revendication 2, **caractérisée en ce que** le premier guidage (4x) est prévu sur la traverse (7) d'un chapiteau (8) en forme de portique de la base de machine (1).

5. Machine-outil selon la revendication 3, **caractérisée en ce que** les deuxièmes guidages (4y) sont prévus sur la face supérieure (9) de la base de machine (1).

6. Machine-outil selon l'une des revendications 1 à 5, **caractérisée en ce qu'**un système de mesure de la position est associé aux différents moyens d'entraînement (5x, 5y) pour les unités de travail (3) et/ou les porte-pièce (2).
